# EUROPEAN PATENT APPLICATION

(11) **EP 0 911 970 A2**
(43) Date of publication of application: **28.04.1999**
(21) Application number: 98307929.4
(22) Date of filing: 29.09.1998
(51) Int. Cl.: H03K 5/12

(54) **Edge detection circuit**

(30) Priority: 09.10.1997 US 61530 P; 03.11.1997 US 963063
(71) Applicant: LUCENT TECHNOLOGIES INC., Murray Hill, New Jersey 07974-0636 (US)
(72) Inventor: Muscavage, Richard, Gilbertsville, Pennsylvania 19525 (US); Segan, Scott A., Allentown, Pennsylvania 18104 (US)
(74) Representative: Buckley, Christopher Simon Thirsk

(57) **Abstract**

An edge signal restoration circuit for enhancing an edge of a signal decreases a rise and fall time of a propagating signal during transitions between logic states. The edge signal restoration circuit (10) includes a first circuit (100) to detect an edge of an input signal (S) and to output a detection signal, and a second circuit (102) to drive a next state of the input signal in response to the detection signal at approximately the same time as the first circuit detects the edge of the input signal. An edge signal restoration method detects a transition of the signal between a current state and a next state, and drives the next state onto the signal during its transition to that next state.

## Description

This application claims priority from U.S. provisional application Serial Number 60/061530, filed on October 9, 1997.

### Field of the Invention

The present invention relates to enhancement of the edges of an electrical signal. More particularly, the present invention relates to a circuit and method for detecting an edge of a digital signal, and driving the next state of the signal based on the detected signal edge to reduce the rise and fall time of the signal.

### Description of the Related Art

Many factors in today's complicated integrated circuits (ICs) limit their maximum operational speed. For instance, ICs typically have long, interconnected electrical wiring inherently exhibiting significant delays from rise and fall times based on the resistance and capacitance of the electrical wiring. This delay is conventionally known as a time constant, and is calculated by the equation T = RC, where T is time in seconds, R is resistance in ohms, and C is capacitance in farads.

All electrical wiring in ICs has some amount of resistance and some amount of capacitance, although it is generally minimized by designing ICs with the shortest possible routes and maximum isolation from other wiring. Nevertheless, the edges of digital signals have exponentially rising and falling edges. Consequently, the resistance and capacitance in the electrical wiring inside ICs leads directly to significant propagation delays.

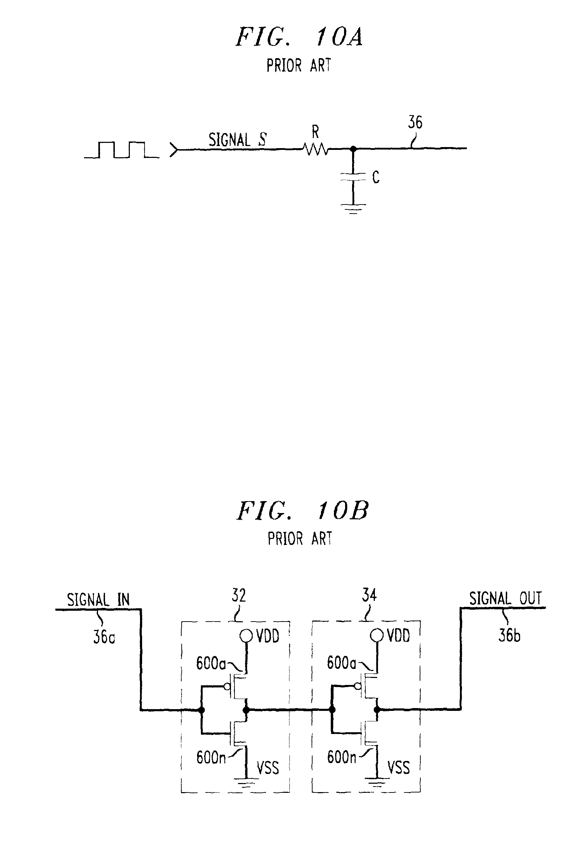

FIG. 10A depicts a wiring path **36** in an IC exhibiting propagation delay because of its resistance and capacitance. One conventional solution to improve excessive propagation delay is to place buffers **32** and **34** in series along the wiring route **36a**, **36b**, as shown in FIG. 10B. In FIG. 10B, an otherwise long wiring route is broken into two parts **36a** and **36b**, and two inverters forming buffers **32** and **34** are placed serially there between. The breaking of the electrical wiring route 36 as shown in FIG. 10A into two parts **36a, 36b** as shown in FIG. 10B increases the overall delay of the signal because a signal must propagate through active buffer components, e.g., at least two metal oxide semiconductor field effect transistors (MOSFETs) **600n, 600p** as shown in FIG. 10B. Moreover, because the wiring route **36** is physically cut into two parts **36a, 36b** (FIG.10B), a contact resistance is added to the circuit because of contacts with the cut portions. These and other factors increase propagation delays even further.

Thus, there is a need to improve the propagation delays in an electrical wiring route of an IC without adding further delays to the overall device speed.

### Summary Of The Invention

In accordance with the principles of the present invention, an edge signal resporation circuit and method to enhance aan edge of a signal are provided which decrease the rise and fall time of the signal. The edge signal restoration circuit includes a first circuit to detect an edge of an input signal and to output a detection signal, and a second circuit to drive a next state of the input signal back onto the input signal at approximately the same time as the first circuit detects the edge of the input signal.

A method of edge signal restoration is also provided by detecting a transition of a signal between a current state and a next state. The next state is then driven back onto the signal during its transition.

### Brief Description of the Drawings

Features and advantages of the present invention will become apparent to those skilled in the art from the following description with reference to the drawings, in which:

FIG. 1 shows an edge signal restoration (ESR) circuit for a wiring route of an IC according to the present invention.

FIG. 2 shows a general configuration of a first embodiment of the ESR circuit according to the present invention.

FIG. 3 is a more detailed circuit diagram of the first embodiment shown in FIG. 2.

FIG. 4 shows a timing diagram for the first embodiment of FIG. 2.

FIG. 5 is a diagram which shows the enhancement of the edges of a signal as a result of an ESR circuit according to the present invention.

FIG. 6 is a detailed timing diagram for the first embodiment shown in FIG. 2.

FIG. 7 shows a general configuration of a second embodiment of the ESR circuit according to the present invention.

FIG. 8 shows a general configuration of a third embodiment of the ESR circuit according to the present invention.

FIG. 9A depicts a conventional wiring route.

FIG. 9B depicts the placement of an ESR circuit along a wiring route to reduce the propagation delay according to the present invention.

FIG. 10A depicts a conventional electrical wiring route of an IC.

FIG. 10B shows a conventional electrical wiring route of an IC which is cut to place a buffer there between.

### Detailed Description of the Illustrative Embodiments

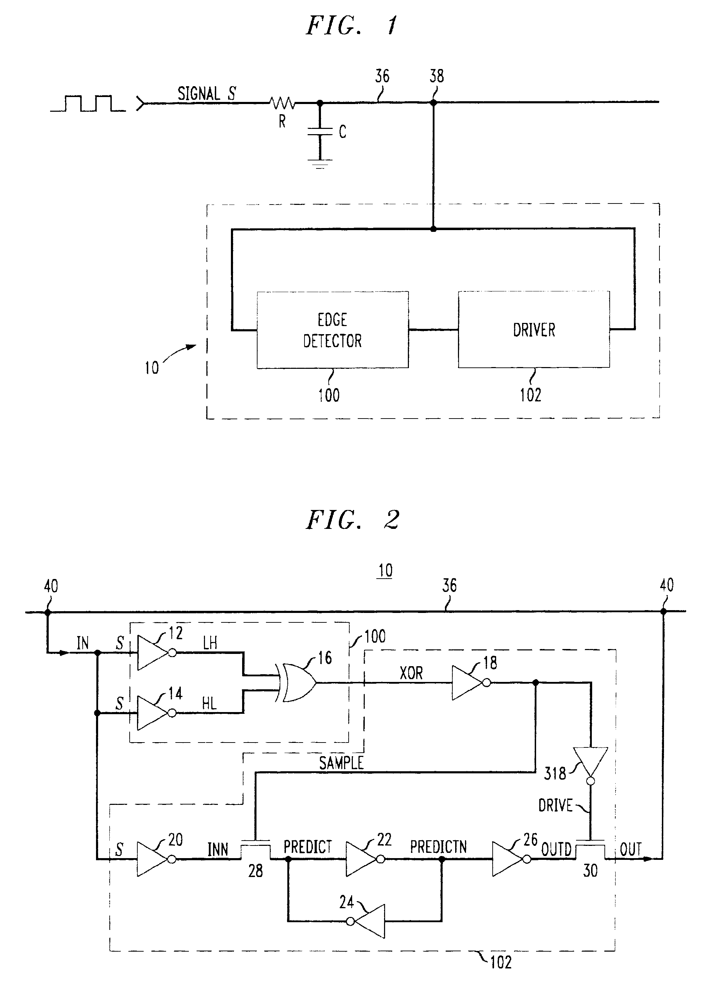

FIG. 1 shows an edge signal restoration (ESR) circuit **10** connected at only a single electrical node **38** of an unbroken wiring route **36** of an IC. A resistor **R** represents a resistance of the wiring route **36** and a capacitor **C** represents the parasitic capacitance of the wiring route **36**.

The ESR circuit **10** includes an edge detector **100** to detect a transition period of a signal **S** either from a logic low state to a logic high state, or from a logic high state to a logic low state at node **38**. This transition period corresponds to a rising and falling edge of signal **S**, respectively. The output of edge detector **100** is fed to driver **102**, which drives a next state of signal **S** back out to node **38** during the transition period. The "next state" of signal **S** is that logic level which the detected transition of signal **S** is progressing toward.

In FIG. 2, reference numeral **10** designates a general configuration of a first embodiment of the ESR circuit **10**. Though FIG. 2 shows that the ESR circuit **10** is connected at two points **40** to an unbroken wiring route **36** of an IC, the ESR circuit **10** is electrically connected at only one electrical node **38** as shown in FIG. **1** because the two points **40** are electrically connected.

In FIG. 2, the edge detector **100** includes inverter **12**, inverter **14** and exclusive OR (XOR) gate **16**. The driver **102** includes inverters **18, 318, 20, 22, 24**, and **26** as well as switches **28** and **30**. Inverters **12** and **14** receive an input signal **S** and output inverted signals **LH, HL**, respectively. The inverted signals **LH, HL** output from inverters **12** and **14** are fed into an XOR gate **16**. The signal **XOR** output from XOR **16** is supplied to inverter **18**. Inverter **18** inverts the **XOR** signal and outputs a signal SAMPLE to the gate of MOSFET transistor switch **28**. The signal **SAMPLE** turns switch **28** ON or OFF in accordance with the logic level of the **SAMPLE** signal. The output of inverter **18** is also supplied to inverter **318** which outputs a signal **DRIVE** to the gate of MOSFET transistor switch **30**. The signal **DRIVE** turns switch 30 ON or OFF in accordance with the logic level of the **DRIVE** signal.

An inverter **20** also receives input signal **S** and outputs an inverted signal **INN** to the drain of switch **28**. The source of switch **28** is connected to the input of inverter **22** and provides signal **PREDICT** to inverter **22**. The output of inverter **22** is connected to the input of inverter **24** and to the input of inverter **26**, providing signal **PREDICTN**. The output of inverter 24 is connected to the input of inverter **22**. The output **OUTD** of inverter **26** is connected to the drain of switch **30**.

The power supply is utilized by all logic devices shown in FIG. 2, and is commonly referred to as 'VDD'. VDD is the power supply voltage of the first embodiment of the ESR circuit **10**. All inverters in the first embodiment of the ESR circuit **10**, except for inverters **12,14**, have conventional CMOS switching points with guaranteed logic levels at approximately 1/3 times the power supply voltage VDD, or (1/3)*VDD, and 2/3 times the power supply voltage VDD, or (2/3)*VDD.

Inverter **12** does not have conventional CMOS switching levels. In one embodiment, the widths of the channels of the CMOS transistors forming inverter **12** are modified to provide an ON/OFF switching point of about 0.3*VDD. When an input voltage to inverter **12** is less than this lower switching point, inverter **12** outputs a logic 1, and when an input voltage to inverter **12** is greater than the lower switching point, inverter **12** outputs a logic 0.

Similarly, inverter **14** does not have conventional CMOS switching levels. The widths of the channels of the CMOS transistors forming inverter **14** are modified to provide an ON/OFF switching point of about 0.7*VDD. When an input voltage to inverter **14** is less than this higher switching point, inverter **14** outputs a logic **1**, and when an input voltage to inverter **14** is greater than the higher switching point, inverter **14** outputs a logic **0**.

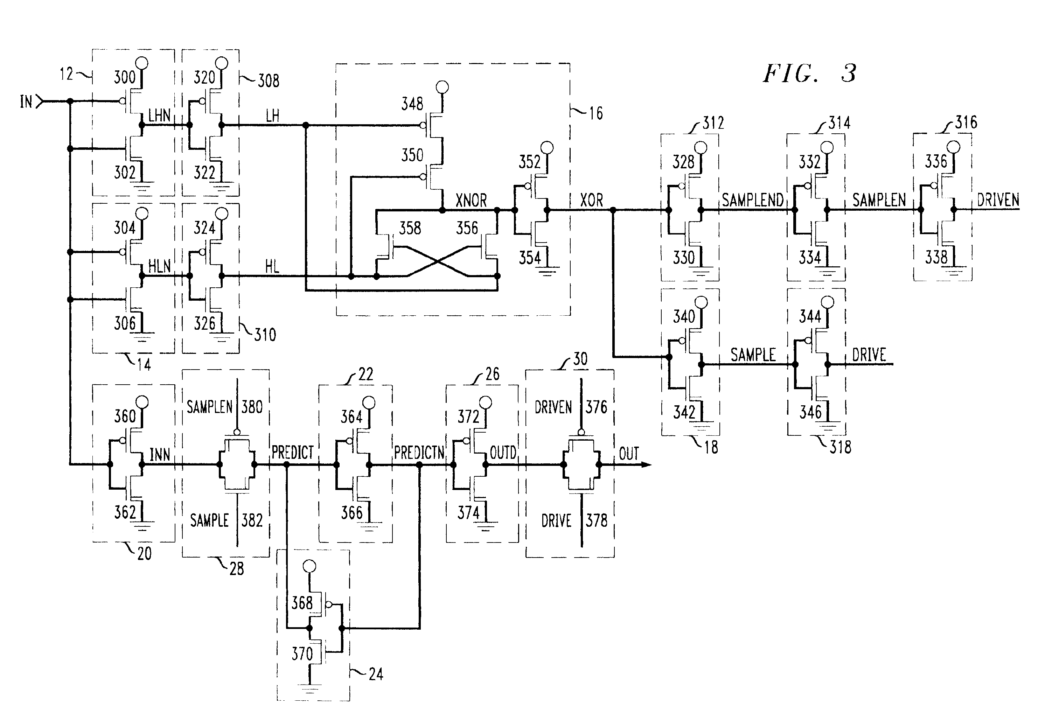

Referring to FIG. 3, which shows the ESR circuit **10** of the present invention in greater detail, each inverter **12, 14** includes a PMOS transistor **300,304** and an NMOS transistor **302, 306,** respectively. Inverters **12** and **14** and XOR **16** detect the rising and falling edges of the signal **S** at different points. In detecting the rising and falling edges, inverter **12** is designed to have a lower switching point of, for example, about 0.3*VDD and inverter **14** is designed to have a higher switching point of, for example, about 0.7*VDD. This is achieved by adjusting the gate length to width ratios of the PMOS transistors **300, 304** and NMOS transistors **302,306** of the inverters **12** and **14,** respectively. For example, if the gates of the PMOS transistors **300,304** are wider than the gates of the NMOS transistors **302,306** within the respective inverter **12,14,** then the transition from logic 0 to logic 1 is faster than if the gate widths were to be formed equal. If the gates of the PMOS transistors **300, 304** are narrower than the gates of the respective NMOS transistors **302,306**, then the transition from logic 0 to logic 1 is slower than if the gate widths were to formed equal.

Inverter **12** is designed to have a PMOS transistor **300** having a gate width which is six times the gate width of the NMOS transistor **302** gate width to obtain a logic transition switching point of, for example, about 0.3*VDD. The inverter **14** is designed to include a PMOS transistor **304** having a gate width which is twice the width of the gate of the NMOS transistor **306** to obtain a logic transition switching point of, for example, about 0.7*VDD. VDD may be 5V, 3.3V or other suitable power supply voltage. The components of the ESR circuit **10** can be scaled to any suitable power supply voltage.

The two example switching points of 0.3*VDD and 0.7*VDD were chosen based on a CMOS load. However, the two switching points may be chosen to be anywhere between 0 and VDD to detect the rising and falling edge of the signal, with due consideration given to compensate for the switching thresholds of the load at the end of the wiring route. For example, two switching points of 0.2*VDD and 0.36*VDD, respectively, may be chosen when using the ESR circuit with TTL logic.

In operation, ESR circuit **10** has two modes, namely, a drive mode and a sample mode. The drive mode occurs either during a rising edge of a digital signal **S** propagating along electrical wiring route **36** or during a falling edge of the digital signal **S**. A rising edge corresponds to a transition from logic state 0 (low) to logic state 1 (high), and a falling edge corresponds to a transition from logic state 1 to logic state 0. The drive mode reduces the rising or falling time of the signal **S** while it is in transition between logic states, and thus enhances the edges of the signal **S** by making the edges of signal **S** more vertical. The sample mode occurs when the ESR circuit **10** is not in the drive mode, but rather is sampling the achieved logic level of the digital signal on electrical wiring route **36** for use in predicting the next state of the signal **S** during a transition from that achieved logic level. In the sample mode, the signal **S** is not yet in transition, i.e., it remains at logic state 0 or logic state 1.

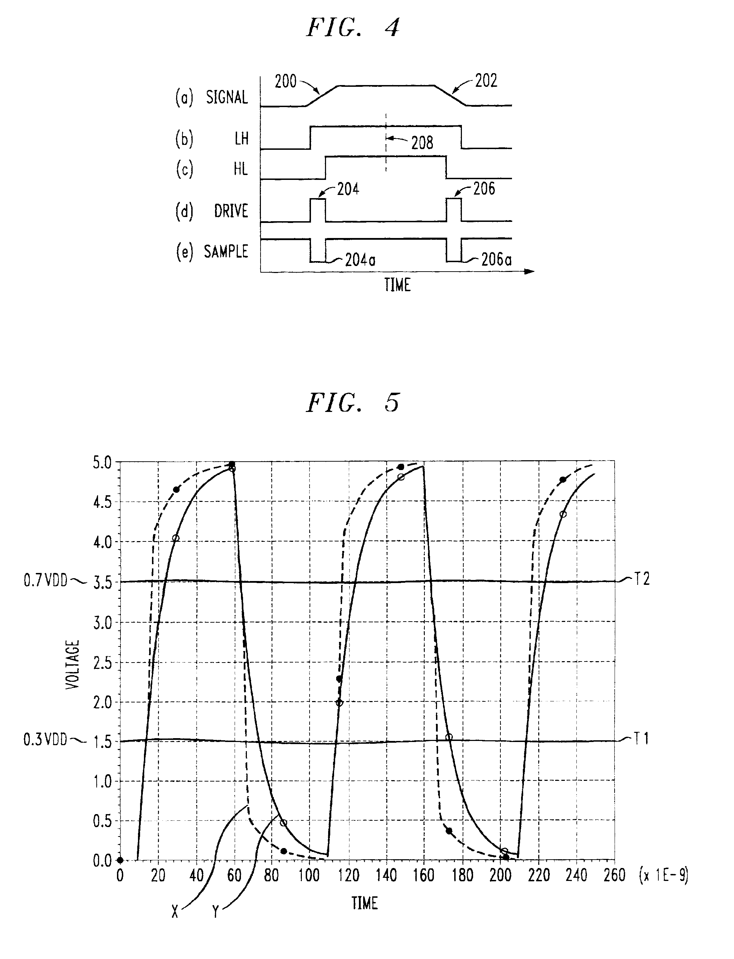

FIG. 4 shows a timing diagram of the first embodiment of the ESR circuit shown in FIG. 2. A signal **S** propagating on electrical wiring route **36** is represented as waveform (a) of FIG. 4. The signal **S** is shown as having linear rising and falling edges for simplicity. However, the rising and falling edges of signal **S** are actually non-linear, and may be exponential. At the first signal edge **200**, i.e., the point at which signal S transitions from logic 0 to logic 1, the output of inverter **12** (i.e., signal **LH** shown in waveform (b) of FIG. 4) switches logic states before the output of inverter **14** (i.e., signal **HL** shown in waveform (c) of FIG. 4). This is because of the different switching points of inverters **12** and **14**. Conversely, at the second signal edge **202,** i.e., the point at which signal **S** transitions from logic 1 to logic 0, the logic state of the output of inverter **14** switches before the logic state of the output of inverter **12.**

Due to the different switching points of inverter **12** and inverter **14**, XOR **16** generates pulses **204, 206** between the different switching points of inverters **12, 14** as shown by the signal **DRIVE** in waveform (d) of FIG. 4. The width of the pulses **204, 206** depends on the switching points chosen for inverter **12** and **14**, and the length of time it takes inverters **12** and **14** to reach the same logic state.

When inverters **12**, **14** are in a state having different output logic levels, then the output of inverter **18** is driven to a logic 0 and the output of inverter **318** is driven to a logic 1. The pulses **204a, 206a** of the signal **SAMPLE** shown in waveform (e) of FIG. 4 turn switch **28** OFF. The pulses **204,206** of the DRIVE signal shown in waveform (d) of FIG. 4 turn switch **30** ON to drive, and thus enhance the predicted logic level of signal **S** from inverter **26** through switch **30,** and back to the electrical wiring route **36.**

Once inverters **12** and **14** have the same output logic level at point **208** shown in waveforms (b) and (c) of FIG. 4, then the output of inverter **18** is driven to a logic **1** and the output of inverter **318** is driven to a logic 0, causing switch **28** to turn ON and switch **30** to turn OFF. This causes the storage of the complement of signal **S** output from inverter **20** in a register formed by inverters **22** and **24**. Inverter **26** also stores the complement value of signal **S** and increases the drive of the stored signal to predict the next logic state of signal **S**. The complemented logic level output from inverter **26** is driven back onto electrical wiring route **36** to enhance signal **S** when switch **30** turns ON during the drive mode.

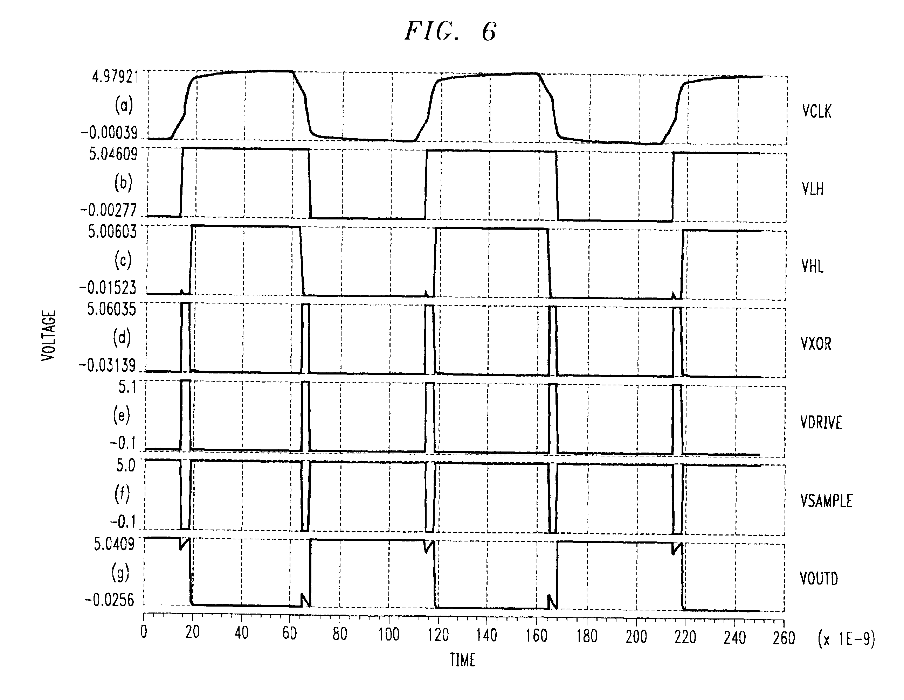

FIG. 5 shows the results of a SPICE simulation comparing the result of the conventional circuit shown in FIG. 10A with that of the circuit of FIG. 1. In FIG. 5, signal **X** (the dotted line) corresponds to the result of using the circuit of FIG. 1. Signal **Y** (the solid line) corresponds to a conventional signal without the present invention, i.e., as shown in FIG. 10A. Signal **X** of the present invention has much sharper edges than signal **Y**. Signal **X** also has a decreased rise/fall time and a shorter propagation time than signal **Y**.

The ESR circuit **10** detects an edge of a signal, i.e., a transition of signal **S** between the chosen switching points **T1** and **T2** as shown in FIG. 5, and then drives the predicted next signal. As shown, the switching points **T1**, **T2** are set to about 0.3*VDD and 0.7*VDD, respectively. If the current logic state is logic 0, a transition results in a predicted next logic state of logic 1. If the current logic state is 1, a transition results in a predicted next logic state of logic 0. The present invention detects the occurrence of a transition from a known logic state, and drives signal **S** to the next logic state faster by driving the predicted next state onto the signal **S** during its transition to that next level in the transition region between transition points **T1** and **T2** (see FIG. 5), thereby enhancing the edges of signal **S**.

As can be seen from FIG. 5, the signal **S** is driven to the next state at approximately the same time that the rising or falling edge of the signal **S** is detected. This occurs in the transition region between transition points **T1** and **T2**. As seen from the results shown in FIG. 5, the ESR circuit **10** of the first embodiment with the chosen switching points of 0.3*VDD and 0.7*VDD drives the next state of the signal **S** at approximately 2V and detects the edge at approximately 1.5V. The delay from detecting the rising or falling edge of signal **S** to driving the next state of signal **S** is simulated to be about 0.5 nsec. This slight delay is due to the propagation time through the inverters of the ESR circuit **10**.

When the ESR circuit **10** stops driving the next state, its output goes to a high impedance state which isolates the driver from the load. FIG. 5 shows that the ESR circuit **10** stops driving the next state at approximately 4.1V. However, this level may vary. For instance, the ESR circuit **10** may be designed to drive until the signal **S** reaches as high as VDD (or as low as OV). The points at which the next state is driven are chosen based on the characterization of the load with the objective being to switch the load quickly.

Referring again to FIG. 3, because the switching points of inverters **12** and **14** are modified from those of conventional CMOS inverters, their drive capabilities are reduced. Thus, inverters **308** and **310** follow inverters **12** and **14**, respectively, to increase the drive capabilities of inverted signals LH and HL to obtain enough power to drive the XOR **16**. Inverter **308** includes a PMOS transistor **320** and an NMOS transistor **322**, and inverter **310** includes a PMOS transistor **324** and an NMOS transistor **326.** The switching or transition points of inverters **308** and **310** are approximately equal, in accordance with conventional CMOS levels. Though inverters **308** and **310** invert the signals from inverters **12** and **14**, this ultimately has no effect due to the logical function of XOR **16**.

XOR **16** includes six MOS transistors **348, 350, 352, 354, 356** and **358** in a conventional configuration. Inverter **18** includes a PMOS transistor **340** and an NMOS transistor **342**, inverter **318** includes a PMOS transistor **344** and an NMOS transistor **346**, inverter **20** includes a PMOS transistor **360** and an NMOS transistor **362**, inverter **22** includes a PMOS transistor **364** and an NMOS transistor **366**, inverter **24** includes a PMOS transistor **368** and an NMOS transistor **370** and inverter **26** includes a PMOS transistor **372** and an NMOS transistor **374**, all in conventional configurations using conventional threshold devices.

Furthermore, switch **28** includes a PMOS transistor **380** to pass a logic 1 signal without any substantial degradation and an NMOS transistor **382** to pass a logic 0 signal without any substantial degradation. Switch **30** includes a PMOS transistor **376** to pass a logic 1 signal without any substantial degradation and an NMOS transistor **378** to pass a logic 0 signal without any substantial degradation. An NMOS transistor has a high resistance to pass a logic 1 signal and a low resistance to pass a logic 0 signal. A PMOS transistor has a high resistance to pass a logic 0 signal and a low resistance to pass a logic 1 signal.

Following the XOR gate **16,** inverters **312, 314** and **316** balance the timing with inverter **18** and inverter **318**. The signal propagation time through inverter **18** equals that through inverters **312** and **314**. Thus, the signal **SAMPLEN** switches logic states at the same time as the signal **SAMPLE.** For example, the signal **SAMPLE** transitions from logic 0 to logic 1 at the same time as signal **SAMPLEN** transitions from logic 1 to logic 0. The signal **SAMPLEN** is the complement of signal **SAMPLE**. Similarly, signal **DRIVEN** is the complement of the signal **DRIVE** and the signal **DRIVEN** switches logic states at the same time as the signal **DRIVE.** Furthermore, the signal **DRIVE** switches logic states after the signal **SAMPLE** such that switch **28** switches before switch **30.** Thus, data is first clocked in and then driven out. Inverters **312, 314** and **316**, therefore, control the timing of the switches **28** and **30** and also increase the drive capabilities of the signals **SAMPLE** and **DRIVE**.

FIG. 6 is an actual timing diagram of the ESR circuit **10** in response to a signal **S** exhibiting a delay T=10 nsec. **VCLK** in waveform (a) illustrates the voltage of the input square wave signal **S** at the node **40** of FIG. **2**. The input square wave signal **S** has a frequency of 12 MHZ. **VLH** in waveform (b) shows the voltage of signal **LH** shown in FIGS. 2 and 3, **VHL** in waveform (c) shows the voltage of signal **HL** shown in FIGS. 2 and 3, and **VXOR** in waveform (d) shows the voltage of signal **XOR** shown in FIGS. 2 and 3. **VDRIVE** in waveform (e) has a slight delay from **VXOR** in waveform (d), and corresponds to signal **DRIVE** in FIGS. 2 and 3. **VSAMPLE** in waveform (f) corresponds to the signal **SAMPLE** in FIGS. 2 and 3. **VOUTD** in waveform (g) is the predicted logic state of signal **OUTD** in FIGS. 2 and 3.

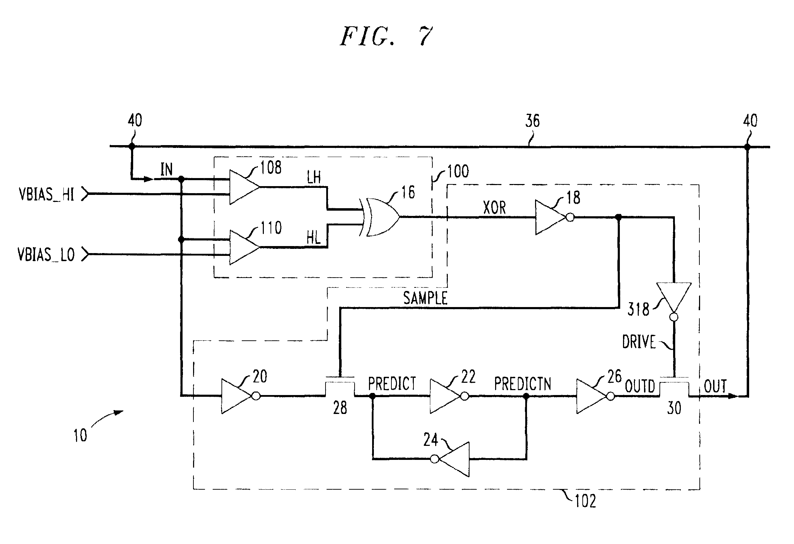

FIG. 7 shows a second embodiment of the ESR circuit **10**. In this embodiment, the edge detector **100** comprises two comparators **108** and **110** which are used to detect an edge or transition period of signal S. The edge detector **100** also includes an XOR gate **16**. In this case, each comparator **108,110** is set with a different switching point by adjusting the bias level of the reference voltage inputs **VBIAS_HI, VBIAS_LO**. Assuming a CMOS load, the voltage reference **VBIAS_HI** input to comparator 108 is set to a voltage level equal to the higher switching point, e.g., 0.7*VDD, and the voltage reference **VBIAS_LO** input to comparator **110** is set to a voltage level equal to the lower switching point, e.g., 0.3*VDD. The driver **102** includes the same components as shown and described with respect to FIG. 2.

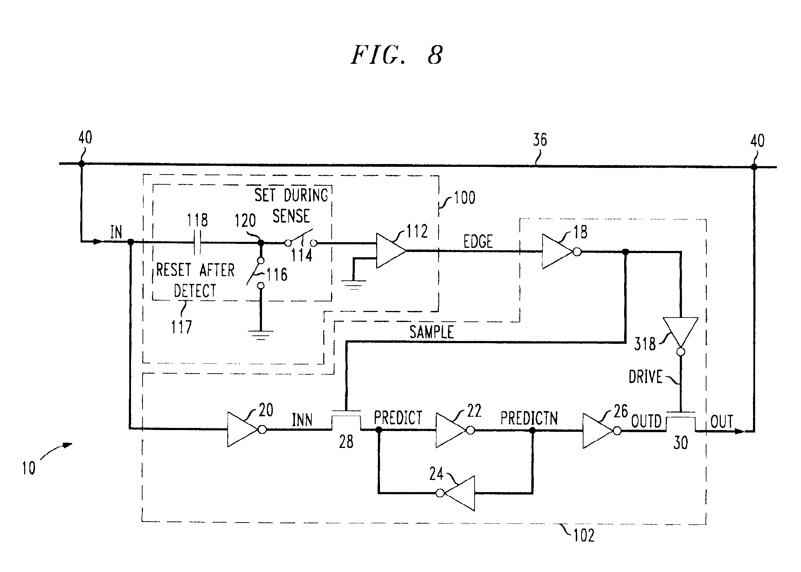

FIG. 8 shows a third embodiment of the ESR circuit **10**. In this embodiment, the edge detector **100** comprises a differentiator **117** and a comparator **112** to detect an edge of signal **S**. The edge detector **100** includes a differentiator **117** and a comparator **112**. The differentiator **117** includes a capacitor **118,** a first switch **114** and a second switch **116**. In this case, there are no switching points in the edge detector **100**. Instead, the differentiator **117** and comparator **112** work together to detect transition of signal **S**. When the signal **S** transitions, the capacitor **118** generates a signal (which is a spike) at node **120.** This spike signal triggers the switch **114** to close, allowing a voltage to be input to comparator **112.** When the voltage input to comparator **112** is greater than ground (i.e., 0 volts) it generates an active **EDGE** signal to activate the **DRIVE** signal and deactivate the **SAMPLE** signal. After the transition is sensed, switch **116** closes to reset the capacitor **118**. Switch **114** is open when signal **S** does not change, and the **EDGE** signal is not generated by comparator **112**. The driver **102** includes the same components as shown in FIG. 2.

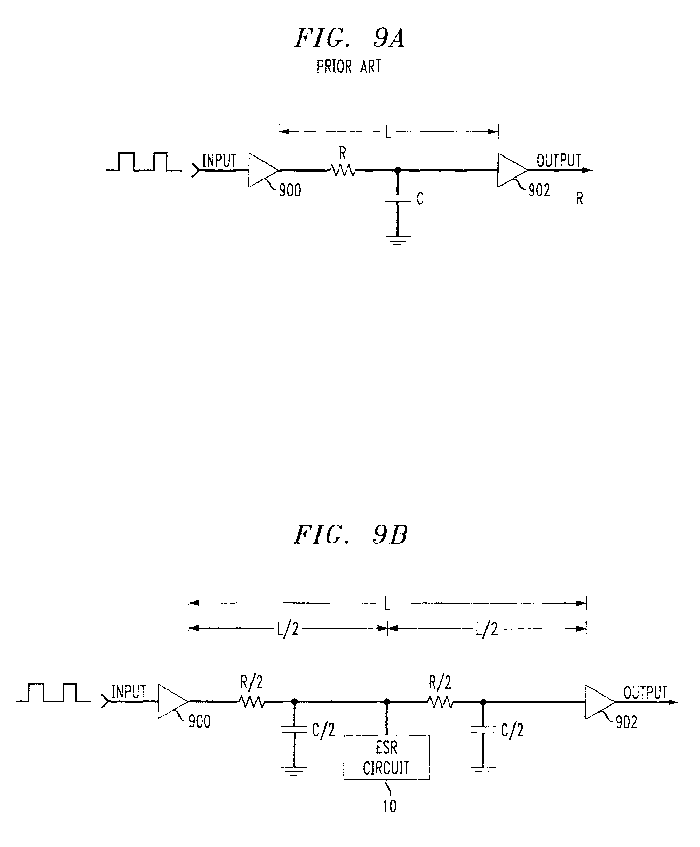

The placement of the ESR circuit **10** with respect to the driver and load affects the RC propagation delay of the signal **S** propagating along electrical wiring route **36**. FIG. 9A shows a signal propagating along a wiring route without the ESR circuit **10**. With a distance L from the signal source **900** to the load **902**, the delay seen by the load is RC. FIG. 9B shows a signal **S** propagating along a wiring route with the ESR circuit **10**. With a distance L from the driver to the load, placing the ESR circuit **10** midway between the driver **900** and the load **902** reduces the delay to that subsequent to the ESR circuit **10**. Thus, as shown in FIG. 9B, the propagation delay seen by the load **902** is R/2 ∗ C/2 = RC/4.

The ESR circuit **10** is small, does not require the wiring route to be broken and does not dissipate static power. The ESR circuit **10** may be used for virtually any digital signal that has a degradation problem. For example, the ESR circuit **10** may be used in a Joint Test Action Group (JTAG) boundary scan chip to reduce the time delay associated therewith. Additionally, the ESR circuit **10** may be used to reduce the clock skew on heavily loaded clocks. The ESR circuit **10** may also be used to decrease RC propagation delay seen by handshaking signals used by bus arbitration data transfers.

While the invention has been described with reference to the exemplary preferred embodiments thereof, those skilled in the art will be able to make various modifications to the described embodiments of the invention without departing from the true spirit and scope of the invention.

## Claims

1. An edge signal restoration circuit comprising:
a first circuit, to detect an edge of an input signal at one electrical node of an electrical wiring route, and to output a detection signal; and
a second circuit to drive a next state signal of said input signal back out to said one electrical node, in response to said detection signal, at approximately a same time as said first circuit detects said edge of said input signal.

2. The edge signal restoration circuit according to claim 1, wherein:
said edge signal restoration circuit connects to an unbroken portion of said electrical wiring route.

3. The edge signal restoration circuit according to claim 1, wherein said first circuit comprises:
a first component having a first switching point; and
a second component having a second switching point different from said first switching point;
wherein said first switching point and said second switching point detect said edge of said input signal at two different points.

4. The edge signal restoration circuit according to claim 3, wherein:
said first component and said second component are each an inverter.

5. The edge signal restoration circuit according to claim 3, wherein:
said first switching point is about 0.3 times a power supply voltage of said edge signal restoration circuit; and
said second switching point is about 0.7 times said power supply voltage.

6. The edge signal restoration circuit according to claim 3, wherein said first circuit further comprises:
an XOR gate, in communication with said first and second components, to generate said detection signal as a pulse during said edge of said input signal;
a width of said pulse being based on said first switching point and said second switching point.

7. The edge signal restoration circuit according to claim 1, wherein:
said second circuit samples said input signal and complements said input signal to generate said next state signal of said input signal.

8. The edge signal restoration circuit according to claim 3, wherein:
said first component and said second component are each a comparator.

9. An edge signal restoration circuit comprising:
a sampler, to sample and complement a present state of an input signal, and to generate a next state signal of said input signal; and
a driver, to detect at least one of a rising edge and a falling edge of said input signal and, at approximately a same time, to drive said generated next state signal back onto said input signal.

10. The edge signal restoration circuit according to claim 9, wherein:
said edge signal restoration circuit connects to only one electrical node of an unbroken electrical wiring route.

11. The edge signal restoration circuit according to claim 9, wherein:
said driver has a first switching point and a second switching point different from said first switching point to detect said at least one of said rising edge and said falling edge of said input signal.

12. The edge signal restoration circuit according to claim 9, wherein:
said driver drives said generated next state only in a transition region of said input signal between reaching said first switching point and said second switching point.

13. A method for enhancing an edge of a signal, comprising:
detecting a transition region of an input signal between a present state and a next state; and
driving a next state signal back onto said input signal substantially only when said signal is passing through said transition region.

14. The method for enhancing according to claim 13, wherein said driving comprises:
driving said next state onto said input signal at approximately a same time as said detecting said transition region of said input signal.

15. The method for enhancing according to claim 13, wherein said detecting comprises:
detecting said input signal at at least two different switching points.

16. An edge signal restoration circuit comprising:
a first detector to detect a transition of an input signal through a first voltage level;
a second detector to detect a transition of said input signal through a second voltage level different from said first voltage level; and
a driver to drive a next logic state of said input signal back onto said input signal.

17. A method for enhancing an edge of a signal, comprising:
detecting a transition of an input signal from a first logic state to a second logic state;
predicting a next state of said input signal; and
driving a next state signal back onto said input signal substantially only during a time that said input signal is in transition between said first logic state and said second logic state.
